# EUROPÄISCHE PATENTSCHRIFT

(11) **EP 3 664 129 B1**
(45) Veröffentlichungstag und Bekanntmachung des Hinweises auf die Patenterteilung: **02.02.2022**
(21) Anmeldenummer: 18210738.3
(22) Anmeldetag: 06.12.2018
(51) Int. Cl.: H01L 21/673, B65D 85/30, B65D 1/36, B65D 21/02, B65D 81/02

(54) **VERPACKUNGSEINHEIT FÜR EIN SUBSTRAT**
PACKAGING UNIT FOR A SUBSTRATE
UNITÉ D'EMBALLAGE POUR UN SUBSTRAT

(43) Veröffentlichungstag der Anmeldung: 10.06.2020
(73) Patentinhaber: Heraeus Deutschland GmbH & Co. KG, 63450 Hanau (DE)
(72) Erfinder: RICHTER, Hans-Jürgen, 63450 Hanau (DE); WACKER, Richard, 63450 Hanau (DE); PELSHAW, Nadja, 63450 Hanau (DE); LÖWER, Yvonne, 63450 Hanau (DE)
(74) Vertreter: Maiwald Patent- und Rechtsanwaltsgesellschaft mbH

(56) Entgegenhaltungen:
- WO-A1-2013/047338
- CN-B- 106 742 537
- DE-B4-102010 018 668
- DE-B4-102012 106 087
- JP-A- 2005 132 438
- JP-A- 2011 016 557
- JP-A- 2011 148 510
- US-B1- 6 296 122

## Beschreibung

### Technisches Gebiet

Die vorliegende Erfindung betrifft eine Verpackungseinheit für ein Substrat, einen Verpackungsstapel mit solchen Verpackungseinheiten und ein Verfahren zur Verpackung eines Substrats.

### Hintergrund der Erfindung

Keramikschaltungsträger sind aufgrund ihrer hohen Wärmeleitfähigkeit, hohen Formstabilität bzw. mechanischen Festigkeit sowie ihrer hohen Isolationsfestigkeit insbesondere im Bereich der Hochleistungselektronik von Interesse.

DE 10 2010 018 668 B4 offenbart eine Verpackungseinheit aus einer Verpackung für Metall-Keramik-Substrate und mehreren Metall-Keramik-Substraten, jeweils bestehend aus einer Keramikschicht und aus auf wenigstens einer Oberflächenseite der Keramikschicht gebildeten Einzelmetallisierung und zwischen diesen verlaufenden Sollbruchlinien.

DE 10 2012 106 087 B4 offenbart eine Verpackungseinheit für Substrate, insbesondere für Metall-Keramik-Substrate, bestehend aus einer Verpackung mit einem aus einem Flachmaterial hergestellten Verpackungsunterteil und einer von einer Vertiefung in einem oberen Bodenabschnitt des Verpackungsunterteils gebildeten Aufnahme für mehrere oder wenigstens einen Substratstapel oder Teilstapel.

Die Dokumente JP2011-148510-A, JP2011-016557A und US6296122-B1 zeigen weitere Verpackungseinheiten für Substrate gemäß des Stands der Technik.

Besonders für empfindliche Substrate und insbesondere Substrate mit empfindlichen Oberflächen oder Oberflächenabschnitten können diese Verpackungen aber noch verbessert werden.

### Zusammenfassung der Erfindung

Es ist daher eine Aufgabe der vorliegenden Erfindung, eine Verpackungseinheit für Substrate bereitzustellen, mit welcher auch empfindliche Substrate sicher verpackt werden können.

Diese Aufgabe wird durch eine Verpackungseinheit für ein Substrat, einen Verpackungsstapel mit einer Vielzahl solcher Verpackungseinheiten und ein Verfahren zur Verpackung eines Substrats nach den unabhängigen Ansprüchen gelöst. Vorteilhafte Ausführungsformen und Weiterbildungen sind den Unteransprüchen und der nachfolgenden Beschreibung zu entnehmen.

Die Verpackungseinheit für ein Substrat umfasst eine erste Schale, ein Substrat und eine zweite Schale. Das Substrat ist in die erste Schale eingelegt und die zweite Schale ist auf die erste Schale aufgesetzt, sodass eine erste Seite des Substrats von der ersten Schale umgeben ist und eine gegenüberliegende, zweite Seite des Substrats von der zweiten Schale überdeckt wird. Auf die zweite Seite des Substrats ist ein Metalldepot aufgebracht und auf dem Metalldepot ist ein Klebepunkt angeordnet. Die zweite Schale stützt sich so an der ersten Schale ab, dass die zweite Schale das Substrat nur außerhalb des Klebepunkts berührt.

Der Vorteil der erfindungsgemäßen Verpackungseinheit liegt darin, dass auch empfindliche Substrate sicher verpackt und insbesondere platzsparend gestapelt werden können, ohne den Klebepunkt auf dem Metalldepot zu berühren. Die erfindungsgemäße Verpackungseinheit ermöglicht, dass das Metalldepot und der Klebepunkt unmittelbar nach dem Herstellen des Substrates durch einen Hersteller oder Weiterverarbeiter des Substrats auf das Substrat aufgebracht werden können und das Substrat mit Metalldepot und Klebepunkt problemlos an einen Weiterverarbeiter oder einen Anwender verschickt werden kann. Auf diese Weise können Weiterverarbeiter oder Anwender des mit Metalldepot und Klebepunkt versehenen Substrats ein weiteres Bauteil direkt auf den Klebepunkt des Substrates aufbringen und beispielsweise mittels eines Löt- oder Sinterverfahrens das Bauteil direkt (ohne eine Vorarbeit zum Fixieren des Bauteils) befestigen. Dieses sogenannte Vorapplizieren des Metalldepots und des Klebepunkts ermöglicht, dass ein weiteres Bauteil kostengünstig auf dem Substrat befestigt werden kann. Bislang werden die Substrate generell ohne vorapplizierte Metall- oder Lotdepots hergestellt und vertrieben. Daher ist es nicht erforderlich, die Substrate anders als durch durchgängige Folien voneinander zu separieren. Im Falle eines Substrats mit vorappliziertem Metalldepot jedoch wird ein Klebepunkt auf das Substrat aufgebracht, der während des Verpackens und Versands der Teile nicht verschmiert oder berührt werden darf. Die erste und die zweite Schale können dazu beitragen, dass die Substrate platzsparend gestapelt, aufbewahrt und/oder transportiert werden können, ohne den Klebepunkt zu berühren.

Das Substrat kann ein beliebiges Trägermaterial sein, welches zum Beispiel nicht sofort fertig verarbeitet wird und daher zunächst zuverlässig aufbewahrt werden muss. Das Substrat kann flächenförmig ausgebildet sein und eine flache ebene Struktur aufweisen. Beispielsweise kann das Substrat in der Halbleitertechnik ein Ausgangsmaterial für eine Fertigung von Elektronikmodulen sein. Das Substrat kann für eine elektronische Anwendung geeignet sein, bei der ein elektronisches Bauteil beispielsweise ein Chip, ein Schalter, ein Beleuchtungselement, ein Kondensator, ein Widerstand oder ähnliches auf das Substrat aufgebracht wird.

Das Substrat weist auf seiner Oberfläche ein sogenanntes Metalldepot auf. Das Metalldepot, in anderen Worten ein Metallvorrat, kann je nach Einsatzzweck ein Metall oder mehrere verschiedene Metalle in bestimmten Mischungsverhältnissen umfassen oder daraus bestehen. Das Metalldepot kann beispielsweise für eine dauerhafte, feste Verbindung von Bauteilen geeignet sein, beispielsweise indem es sich als Schmelze mit der Oberfläche von Bauteilen verbindet bzw. legiert und nach Abkühlung erstarrt oder indem es sich im Sinne eines Sintermaterials ohne zu schmelzen mit der Oberfläche von Bauteilen verbindet. Größe und Dicke des Metalldepots können auch je nach Einsatzzweck variieren.

Auf dem Metalldepot ist ein Klebepunkt angeordnet. Der Klebepunkt kann dazu dienen und dafür gestaltet sein, ein zum Beispiel elektronisches Bauteil auf dem Substrat zu fixieren, um einen darauffolgenden Löt- oder Sintervorgang zwischen dem elektronischen Bauteil und dem Substrat zu erleichtern. Der Klebepunkt kann beim Verlöten oder Sintern des elektronischen Bauteils mit dem Substrat unzersetzt verdampfen und/oder sich unter Zersetzung verflüchtigen, sodass der Klebepunkt keine oder keine störenden Rückstände hinterlässt.

Das flächenförmige Substrat kann eine erste und zweite Seite aufweisen, die jeweils als Unter- und Oberseite bezeichnet werden können. Die "Unterseite" kann eine Oberfläche des Substrats sein, auf welcher weder Metalldepot noch Klebepunkt platziert ist. Im Gegensatz dazu kann eine "Oberseite" eine Oberfläche des Substrats sein, auf welcher das Metalldepot und der Klebepunkt appliziert sind.

Die Verpackungseinheit weist eine erste und eine zweite Schale auf. Zumindest eine der ersten und zweiten Schalen kann wannenförmig ausgebildet sein, um das Substrat im Innenraum der Schale aufzunehmen. Auf diese Weise kann die erste Seite bzw. Unterseite des Substrats von der ersten Schale umgeben sein. Auf die erste Schale, in welche das Substrat eingelegt ist, kann die zweite Schale aufgesetzt werden. In anderen Worten können die erste und zweite Schale in vertikaler Richtung aufeinandergestapelt werden und das Substrat kann zwischen zwei aufeinanderfolgenden Schalen positioniert werden. Somit kann eine Bodenseite der zweiten Schale die zweite Seite bzw. Oberseite des Substrats überdecken.

Die zweite Schale stützt sich so an der ersten Schale ab, dass die zweite Schale das Substrat nur außerhalb des Klebepunkts berührt. In anderen Worten, die zweite Schale berührt den Klebepunkt nicht, weder seitlich noch an der Oberseite des Klebepunkts. Auf diese Weise wird erreicht, dass der Klebepunkt nicht berührt bzw. verschmiert wird. Die zweite Schale kann auch so auf das erste Substrat aufgelegt sein, dass sie das erste Substrat auch nur außerhalb des Metalldepots berührt. Bevorzugt berührt die zweite Schale das Metalldepot weder seitlich noch an der Oberseite des Metalldepots. Auf diese Weise wird erreicht, dass auch das Metalldepot nicht berührt wird.

In einer Ausführungsform ist das Substrat ein Metallkeramiksubstrat. In einer Ausführungsform umfasst das Metallkeramiksubstrat eine Keramikschicht und mindestens eine Metallisierungsschicht, wobei das Metalldepot auf die Metallisierungsschicht aufgebracht ist. In einer Ausführungsform umfasst das Metallkeramiksubstrat die Keramikschicht und zwei Metallisierungsschichten, wobei das Metalldepot auf eine der Metallisierungsschichten aufgebracht ist. In einer Ausführungsform umfasst das Metallkeramiksubstrat eine Keramikschicht und zwei Metallisierungsschichten und beide Metallisierungsschichten weisen eine außenliegende Oberfläche auf, auf die ein Metalldepot aufgebracht ist.

Der Begriff "Metallkeramiksubstrat" kann so verstanden werden, dass das Substrat aus Keramik hergestellt und durch verschiedene Verfahren wie z.B. Direct-Copper-Bonding (üblicherweise als DCB-Verfahren bezeichnet), Direct-Aluminium-Bonding (üblicherweise als DAB-Verfahren bezeichnet) oder Active-Metal-Brazing (üblicherweise als AMB-Verfahren bezeichnet) metallisiert werden kann. Geeignete Materialien für das Keramiksubstrat sind beispielsweise ein Oxid, ein Nitrid, ein Carbid, oder ein Gemisch oder Komposit aus zumindest zweien dieser Materialien, insbesondere ggf. dotierte Aluminiumoxid- oder Siliziumnitrid-Keramik. Das nach der Metallisierung des Keramiksubstrats erhaltene Verbundmaterial wird auch als Metall-Keramik-Substrat oder Metall-Keramik-Verbund bezeichnet. Sofern es beispielsweise durch ein DCB-Verfahren hergestellt wurde, wird häufig auch die Bezeichnung "DCB-Substrat" verwendet.

Eine Metallisierung des Keramiksubstrats kann beispielsweise dadurch realisiert werden, dass zunächst eine Metallfolie oxidiert wird, sodass sich an deren Oberfläche eine Metalloxidschicht bildet. Die oxidierte Metallfolie wird auf das Keramiksubstrat aufgelegt und das Keramiksubstrat mit der oxidierten Metallfolie erhitzt.

Das Substrat kann ein Direct Copper Bonding (DCB) oder ein Direct Aluminium Bonding (DAB) Substrat sein, welches eine gute elektrische und thermische Verbindung elektronischer Bauteile und Chips über Kupfer bzw. Aluminium ermöglicht.

Das Metalldepot kann im Falle eines lötbaren Metalls durch Löten, beispielsweise durch ein Vakuumlöten in einer aktiven Atmosphäre mit Ameisensäureaktivierung, auf das Metallkeramiksubstrat aufgebracht werden. Im Falle eines sinterbaren Metalls kann das Metalldepot durch Sintern oder Ansintern auf das Metallkeramiksubstrat aufgebracht werden. Das Metalldepot kann auf dem Metallkeramiksubstrat in einem definierten Volumen, an einer definierten Position und mit einer definierten Form appliziert werden. Auf diese Weise kann das Metallkeramiksubstrat ohne einen Metallpastendruck und/oder einen Reinigungsvorgang weiterverarbeitet werden. Dies ermöglicht, dass ein weiteres Bauteil, beispielsweise ein Chip, ein Schalter, ein Beleuchtungselement, ein Kondensator, ein Widerstand oder ähnliches auf das Substrat bzw. Metalldepot vereinfacht aufgebracht und dort beispielsweise ohne Verwendung von Hilfsstoffen wie beispielsweise Flussmitteln, Reinigungsmitteln und ähnlichem befestigt werden kann.

In einer Ausführungsform umfasst das Metalldepot ein lötbares oder sinterbares Metall oder eine lötbare oder sinterbare Legierung. Das Metalldepot kann auch als ein Lot- oder Sinterdepot verstanden werden und ein bestimmtes Volumen aufweisen oder eine Metall-/Legierungsschicht sein. Das Metalldepot kann ein lötbares oder sinterbares Metall oder eine lötbare oder sinterbare Legierung sein.

In einer Ausführungsform ist der Klebepunkt bei Raumtemperatur verschmierbar. Verschmierbar bedeutet, dass der Klebepunkt nach dem Applizieren auf den Metalldepots beispielsweise angetrocknet sein kann, jedoch an der Luft nicht fest oder hart wird, sondern klebrig oder schmierig bleibt. Der verschmierbare Klebepunkt ist weder vollständig fest noch vollständig flüssig. Er kann eine bestimmte Viskosität aufweisen, sodass sich beispielsweise ein auf den Klebepunkt aufgebrachtes weiteres Bauteil selbst bei einer zum Beispiel 90° schrägen Lage des Substrats nicht selbstständig bewegt oder selbstständig rutschen kann.

Das Substrat kann aber auch auf beiden Seiten jeweils ein Metalldepot und auch einen Klebepunkt umfassen. Das bedeutet, dass das Substrat sowohl auf seiner Oberseite als auch auf seiner Unterseite ein Metalldepot und auch einen Klebepunkt aufweisen kann. Die erste und die zweite Schale können so eingerichtet sein, dass der in vertikaler Richtung (senkrecht zur Substratfläche) nach oben gerichtete Klebepunkt nicht mit der äußeren Bodenseite der zweiten Schale und der in vertikaler Richtung nach unten gerichtete Klebepunkt nicht mit der inneren Bodenseite der ersten Schale in Berührung kommen.

In einer Ausführungsform weist die erste Schale und/oder die zweite Schale mindestens einen Abstandshalter zum Abstützen an der jeweils anderen Schale und/oder an dem Substrat auf. Der Abstandshalter kann beispielsweise an zumindest einer Wand der ersten und/oder der zweiten Schale ausgebildet sein, um sich an der jeweils anderen Schale abzustützen. Alternativ kann sich die äußere Bodenseite der zweiten Schale an dem Abstandshalter der ersten Schale abstützen. Der Abstandshalter kann beispielsweise punktförmig, stegförmig, kegelförmig oder ähnlich geformt sein oder entlang der Wand der ersten und/oder der zweiten Schale verlaufen.

In einer Ausführungsform umfasst die erste Schale einen Boden und eine umlaufende Wand und die umlaufende Wand erstreckt sich vom Boden bis in eine Wandhöhe, die zwischen der Höhe des Substrats und der doppelten Höhe des Substrats liegt. In anderen Worten, die Wandhöhe ist größer als die Höhe bzw. Dicke eines Substrats und kleiner als die Höhe bzw. Dicke von zwei Substraten. In anderen Worten kann die erste Schale so eingerichtet sein, dass sie nur ein Substrat und nicht zwei Substrate aufnehmen kann. Das kann bedeuten, dass die Wandhöhe so groß ist wie die Höhe bzw. Dicke des Substrats plus einem Sicherheitsabstand. Noch genauer, die Wand kann eine Höhe aufweisen, die mindestens eine Summe der Höhe von Substrat, Metalldepot, Klebepunkt und Sicherheitsabstand beträgt. Der Sicherheitsabstand kann zum Beispiel 50 µm betragen. Die Wand der ersten Schale kann eine Höhe zwischen 200 und 1000 µm aufweisen.

Der Boden der ersten Schale kann beispielsweise eine rechteckige Form aufweisen, um ein Substrat aufzunehmen, welches im Wesentlichen rechteckig eingerichtet ist. Die umlaufende Wand der ersten Schale kann senkrecht zum Boden der Schale stehen oder sich allmählich vom Boden in Richtung eines freien Endes der Schale aufweiten. In einer Ausführungsform weist die umlaufende Wand in Richtung des Bodens eine geringere Außenabmessung als an ihrem freien Ende auf. In anderen Worten die umlaufende Wand der ersten Schale kann kegelförmig ausgebildet sein, sodass sich die Wand in Richtung des freien Endes der Schale aufweitet. Auf diese Weise kann die zweite Schale einfach von der ersten Schale getrennt werden.

In einer Ausführungsform weist die erste Schale mindestens ein Fixierungselement zur seitlichen Fixierung des Substrats relativ zu der ersten Schale und/oder der zweiten Schale auf. Das Fixierungselement kann verhindern, dass sich das Substrat beim Transport bewegt bzw. seitlich zusammengedrückt wird. Das Fixierungselement kann gleichzeitig auch ein Abstandshalter zum Abstützen an der jeweils anderen Schale und/oder an dem Substrat sein. Das Fixierungselement kann punktförmig, stegförmig, kegelförmig oder ähnlich geformt sein.

In einer Ausführungsform sind die erste Schale und die zweite Schale baugleich. Die erste und zweite Schale können aber auch beispielsweise je nach Größe und Position des Metalldepots und des Klebepunkts unterschiedlich ausgelegt sein.

In einer Ausführungsform umfasst das Substrat eine Vielzahl von nebeneinander angeordneten Einzelsubstraten. Das Einzelsubstrat kann in Form eines oben beschriebenen Substrats vorliegen. Alternativ ist es auch möglich, dass das Substrat eine oder mehrere (bevorzugt geradlinig verlaufende) Sollbruchlinien aufweist, die das Substrat in zwei oder mehr Bereiche unterteilen.

In einer Ausführungsform sind die erste Schale und die zweite Schale aus Kunststoff oder Karton. Auf diese Weise können die Schalen kostengünstig, leicht und einfach hergestellt werden. Die erste und die zweite Schale können aber auch aus unterschiedlichen Materialien hergestellt werden. Die Materialien können dabei durchsichtig ausgebildet sein.

In einer Ausführungsform umfasst die Verpackungseinheit ein weiteres Substrat, welches in die zweite Schale eingelegt ist. Selbstverständlich kann die Verpackungseinheit eine Vielzahl von abwechselnd angeordneten Substraten und Schalen umfassen. Auf diese Weise können Substrate und Schalen platzsparend gestapelt werden. Eine Schale, welche am oberen Ende der Verpackungseinheiten aufgelegt wird, kann einen Abschluss der Verpackungseinheit bilden.

Die vorliegende Erfindung umfasst weiterhin einen Verpackungsstapel, welcher eine Vielzahl von aufeinandergestapelten Verpackungseinheiten umfasst. Durch eine relativ flache Konfiguration des Substrats und der Schale kann es möglich sein, dass eine Vielzahl von Substraten und Schalen platzsparend aufeinandergestapelt werden. Die Abstandshalter der ersten und zweiten Schale können ermöglichen, dass die Klebepunkte auf den Metalldepots trotz des Stapelns von mehreren Substraten und Schalen berührungsfrei bleiben. Der Verpackungsstapel kann je nach Einsatzzweck und Lagerkapazität eine beliebige Anzahl von Verpackungseinheiten aufweisen.

In einer Ausführungsform umfasst der Verpackungsstapel ein Stabilisierungselement, welches den Abschluss des Verpackungsstapels bildet. Das Stabilisierungselement kann beispielsweise eine weitere Schale sein, auf welche kein Substrat mehr aufgelegt wird. Alternativ kann das Stabilisierungselement auch ein Deckel oder eine Folie sein, die den Abschluss des Verpackungsstapels bilden. Das Stabilisierungselement kann als eine Schutzabdeckung dienen und unter Vakuum stabil bleiben ohne sich zu biegen, wenn der Verpackungsstapel vakuumiert werden soll.

Die vorliegende Erfindung umfasst weiterhin ein Verfahren zur Verpackung eines Substrats. Das Verfahren umfasst die folgenden Schritte:
- Bereitstellen einer ersten Schale,
- Einlegen eines Substrats in die erste Schale, und
- Aufsetzen einer zweiten Schale auf die erste Schale.

Eine erste Seite des Substrats ist von der ersten Schale umgeben und eine gegenüberliegende, zweite Seite des Substrats wird von der zweiten Schale überdeckt, wobei auf die zweite Seite des Substrats ein Metalldepot aufgebracht ist und auf dem Metalldepot ein Klebepunkt angeordnet ist. Die zweite Schale stützt sich so an der ersten Schale ab, dass die zweite Schale das Substrat nur außerhalb des Klebepunkts berührt.

Weitere Merkmale, Vorteile und Anwendungsmöglichkeiten der vorliegenden Erfindung ergeben sich aus der nachfolgenden Beschreibung, den Ausführungsbeispielen und den Figuren. Alle beschriebenen und/oder bildlich dargestellten Merkmale können unabhängig von ihrer Darstellung in einzelnen Ansprüchen, Figuren, Sätzen oder Absätzen miteinander kombiniert werden. In den Figuren stehen gleiche Bezugszeichen für gleiche oder ähnliche Objekte.

### Kurze Beschreibung der Figuren

Figur 1 zeigt eine Verpackungseinheit gemäß einer Ausführungsform.
Figur 2 zeigt eine Verpackungseinheit gemäß einer Ausführungsform.
Figur 3 zeigt ein Metallkeramiksubstrat gemäß einer Ausführungsform.
Figur 4 zeigt einen Verpackungsstapel gemäß einer Ausführungsform.

### Detaillierte Beschreibung der Ausführungsbeispiele

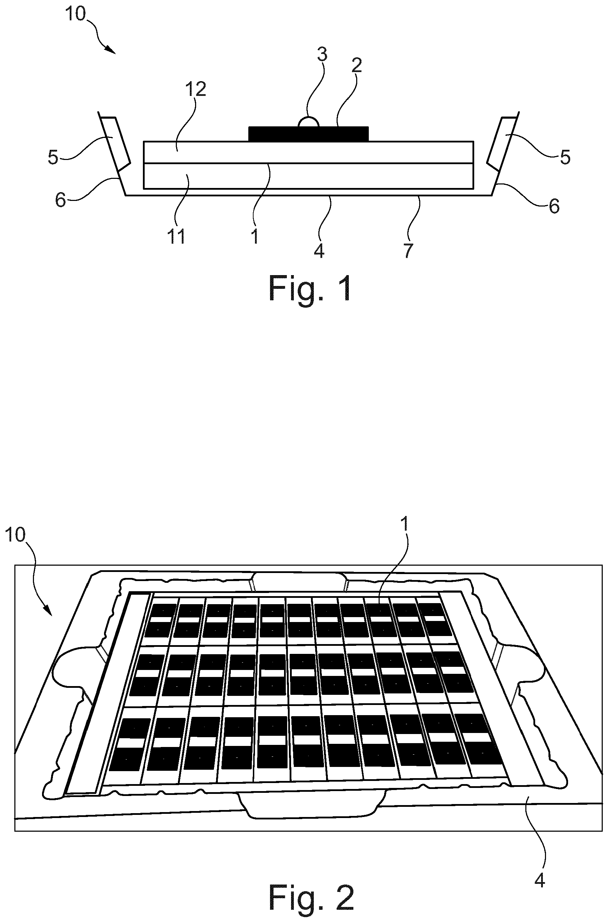

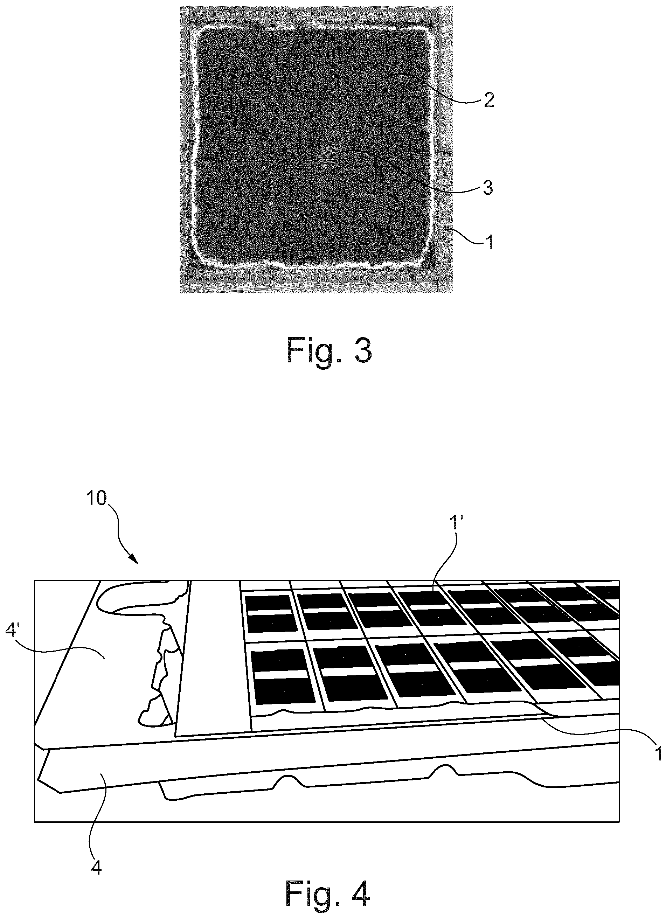

Figur 1 und Figur 2 zeigen eine Verpackungseinheit 10 für ein Metallkeramiksubstrat 1. Die Verpackungseinheit 10 umfasst eine erste Schale 4, eine zweite Schale 4' (in Figur 4) und ein Substrat 1. Das Substrat 1 kann durch ein Direct Copper Bonding (DCB) Verfahren oder Direct Aluminium Bonding (DAB) Verfahren hergestellt werden und eine Vielzahl von nebeneinander angeordneten Einzelsubstraten umfassen (Figur 2). Das Substrat 1 ist in die erste Schale 4 eingelegt und die zweite Schale 4' (in Figur 4) ist auf die erste Schale 4 aufgesetzt, so dass eine Unterseite des Substrats 1 von der ersten Schale 4 umgeben ist und eine gegenüberliegende Oberseite des Substrats 1 von der zweiten Schale 4' überdeckt wird.

Das Substrat 1 umfasst eine Keramikschicht 11 und mindestens eine Metallisierungsschicht 12. Das Substrat 1 weist vorzugsweise insgesamt zwei Metallisierungsschichten auf, nämlich die Metallisierungsschicht 12 und eine nicht gezeigte weitere Metallisierungsschicht auf der anderen Seite der Keramikschicht 11. Wie auch in Figur 3 gezeigt, ist auf eine Oberseite der Metallisierungsschicht 12 des Substrats 1 ein Metalldepot 2 aufgebracht und auf dem Metalldepot 2 ist ein Klebepunkt 3 angeordnet. Das Metalldepot 2 umfasst ein lötbares oder sinterbares Metall oder eine lötbare oder sinterbare Legierung. Der Klebepunkt 3 ist bei Raumtemperatur bzw. in Luft klebrig und verschmierbar. Auf dem Klebepunkt 3 kann ein elektronisches Bauteil beispielsweise ein Chip, Leuchtmittel, Widerstand, Kondensator etc. aufgebracht werden.

Die erste und die zweite Schale 4, 4' können baugleich ausgebildet sein und aus Kunststoff oder Karton hergestellt sein. Die erste und die zweite Schale 4, 4' umfassen einen Boden 7 und eine umlaufende Wand 6. Die umlaufende Wand 6 erstreckt sich vom Boden 7 bis in eine Wandhöhe, in der nur ein Substrat 1 plus ein Sicherheitsabstand umschlossen wird. Die umlaufende Wand 6 weist in Richtung des Bodens 7 eine geringere Außenabmessung als an ihrem freien Ende auf. Die erste Schale 4 und/oder die zweite Schale 4' weist mindestens einen Abstandshalter 5 zum Abstützen an der jeweils anderen Schale und/oder an dem Substrat 1 auf. Ferner, die erste und die zweite Schale 4, 4' können ein Fixierungselement (nicht gezeigt) zur seitlichen Fixierung des Substrats 1 relativ zu der ersten Schale 4 und/oder zu der zweiten Schale 4' aufweisen. Das Fixierungselement kann beispielsweise ein verlängerter Abstandshalter sein oder separat auf der Höhe der Keramikschicht 11 oder Metallisierungsschicht 12 eingerichtet sein. Wenn die zweite Schale 4' auf die erste Schale 4 aufgesetzt wird, soll sich die zweite Schale 4' so an der ersten Schale 4 abstützen, dass die zweite Schale 4 das Substrat 1 nur außerhalb des Klebepunkts 3 berührt.

Wie in Figur 4 gezeigt, kann die Verpackungseinheit 10 weiterhin ein weiteres Substrat 1' aufweisen, welches auf die zweite Schale 4' aufgelegt wird. Auf diese Weise kann ein Verpackungsstapel realisiert werden, welcher eine Vielzahl von aufeinandergestapelten Verpackungseinheiten 10 umfasst und platzsparend aufbewahren und/oder transportieren kann, ohne die Klebepunkte der Substrate zu berühren. Der Verpackungsstapel kann ferner ein Stabilisierungselement (nicht gezeigt) umfassen, welches den Abschluss des Verpackungsstapels bildet.

Ergänzend sei darauf hingewiesen, dass "umfassend" und "aufweisend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkungen anzusehen.

Der Schutzbereich des europäischen Patents und der europäischen Patentanmeldung wird durch die Patentansprüche bestimmt. Die Beschreibung und die Zeichnungen sind jedoch zur Auslegung der Patentansprüche heranzuziehen.

## Patentansprüche

1. Eine Verpackungseinheit (10) für ein Substrat (1), umfassend:
- eine erste Schale (4),
- ein Substrat (1), und
- eine zweite Schale (4'),
wobei das Substrat (1) in die erste Schale (4) eingelegt ist und die zweite Schale (4') auf die erste Schale (4) aufgesetzt ist, sodass eine erste Seite des Substrats (1) von der ersten Schale (4) umgeben ist und eine gegenüberliegende, zweite Seite des Substrats (1) von der zweiten Schale (4') überdeckt wird,
wobei auf die zweite Seite des Substrats (1) ein Metalldepot (2) aufgebracht ist und auf dem Metalldepot (2) ein Klebepunkt (3) angeordnet ist, und
wobei sich die zweite Schale (4') so an der ersten Schale (4) abstützt, dass die zweite Schale (4') das Substrat (1) nur außerhalb des Klebepunkts (3) berührt,
wobei die erste Schale (4) einen Boden (7) und eine umlaufende Wand (6) umfasst, und
wobei sich die umlaufende Wand (6) vom Boden (7) bis in eine Wandhöhe erstreckt, die zwischen der Höhe des Substrats (1) und der doppelten Höhe des Substrats (1) liegt.

2. Verpackungseinheit nach Anspruch 1, wobei das Substrat (1) ein Metallkeramiksubstrat ist.

3. Verpackungseinheit nach dem vorherigen Anspruch, wobei das Metallkeramiksubstrat (1) eine Keramikschicht (11) und mindestens eine Metallisierungsschicht (12) umfasst und das Metalldepot (2) auf die Metallisierungsschicht (12) aufgebracht ist.

4. Verpackungseinheit nach einem der vorherigen Ansprüche, wobei das Metalldepot (2) ein lötbares oder sinterbares Metall oder eine lötbare oder sinterbare Legierung umfasst.

5. Verpackungseinheit nach einem der vorherigen Ansprüche, wobei die erste Schale (4) und/oder die zweite Schale (4') mindestens einen Abstandshalter (5) zum Abstützen an der jeweils anderen Schale und/oder an dem Substrat (1) aufweist.

6. Verpackungseinheit nach dem vorherigen Anspruch, wobei die umlaufende Wand (6) in Richtung des Bodens (7) eine geringere Außenabmessung aufweist als an ihrem freien Ende.

7. Verpackungseinheit nach einem der vorherigen Ansprüche, wobei die erste Schale (4) und die zweite Schale (4') baugleich sind.

8. Verpackungseinheit nach einem der vorherigen Ansprüche, wobei der Klebepunkt (3) gestaltet ist, um ein elektronisches Bauteil auf dem Substrat (1) zu fixieren.

9. Verpackungseinheit nach einem der vorherigen Ansprüche, wobei das Substrat (1) eine Vielzahl von nebeneinander angeordneten Einzelsubstraten umfasst.

10. Verpackungseinheit nach einem der vorherigen Ansprüche, wobei die erste Schale (4) und die zweite Schale (4') aus Kunststoff oder Karton sind.

11. Verpackungseinheit nach einem der vorherigen Ansprüche, weiterhin umfassend ein weiteres Substrat (1'), welches in die zweite Schale (4') eingelegt ist.

12. Ein Verpackungsstapel, umfassend eine Vielzahl von aufeinandergestapelten Verpackungseinheiten nach einem der vorherigen Ansprüche.

13. Verpackungsstapel nach dem vorherigen Anspruch, weiterhin umfassend ein Stabilisierungselement, welches den Abschluss des Verpackungsstapels bildet.

14. Ein Verfahren zur Verpackung eines Substrats (1), umfassend die folgenden Schritte:
- Bereitstellen einer ersten Schale (4),
- Einlegen eines Substrats (1) in die erste Schale (4), und
- Aufsetzen einer zweiten Schale (4') auf die erste Schale (4),
sodass eine erste Seite des Substrats (1) von der ersten Schale (4) umgeben ist und eine gegenüberliegende, zweite Seite des Substrats (1) von der zweiten Schale (4') überdeckt wird,
wobei auf die zweite Seite des Substrats (1) ein Metalldepot (2) aufgebracht ist und auf dem Metalldepot (2) ein Klebepunkt (3) angeordnet ist, und
wobei sich die zweite Schale (4') so an der ersten Schale (4) abstützt, dass die zweite Schale (4') das Substrat (1) nur außerhalb des Klebepunkts (3) berührt,
wobei die erste Schale (4) einen Boden (7) und eine umlaufende Wand (6) umfasst, und
wobei sich die umlaufende Wand (6) vom Boden (7) bis in eine Wandhöhe erstreckt, die zwischen der Höhe des Substrats (1) und der doppelten Höhe des Substrats (1) liegt.

## Claims

1. A packaging unit (10) for a substrate (1), comprising:
- a first tray (4),
- a substrate (1), and
- a second tray (4'),
wherein the substrate (1) is inserted into the first tray (4) and the second tray (4') is placed onto the first tray (4), so that a first side of the substrate (1) is surrounded by the first tray (4), and an opposite, second side of the substrate (1) is covered by the second tray (4'),
wherein a metal deposit (2) is applied to the second side of the substrate (1), and an adhesive point (3) is arranged on the metal deposit (2), and
wherein the second tray (4') is supported on the first tray (4) in such a way that the second tray (4') touches the substrate (1) only outside the adhesive point (3),
wherein the first tray (4) comprises a bottom (7) and a circumferential wall (6), and
wherein the circumferential wall (6) extends from the bottom (7) to a wall height which lies between the height of the substrate (1) and twice the height of the substrate (1).

2. Packaging unit according to claim 1, wherein the substrate (1) is a metal-ceramic substrate.

3. Packaging unit according to the preceding claim, wherein the metal-ceramic substrate (1) comprises a ceramic layer (11) and at least one metalization layer (12), and the metal deposit (2) is applied to the metalization layer (12).

4. Packaging unit according to one of the preceding claims, wherein the metal deposit (2) comprises a solderable or sinterable metal, or a solderable or sinterable alloy.

5. Packaging unit according to one of the preceding claims, wherein the first tray (4) and/or the second tray (4') has at least one spacer (5) for support on the respective other tray and/or on the substrate (1).

6. Packaging unit according to the preceding claim, wherein the circumferential wall (6) has a smaller external dimension in the direction of the bottom (7) than at its free end.

7. Packaging unit according to one of the preceding claims, wherein the first tray (4) and the second tray (4') are identical in design.

8. Packaging unit according to one of the preceding claims, wherein the adhesive point (3) is designed to affix an electronic component to the substrate (1).

9. Packaging unit according to one of the preceding claims, wherein the substrate (1) comprises a plurality of adjacently-arranged, individual substrates.

10. Packaging unit according to one of the preceding claims, wherein the first tray (4) and the second tray (4') are made of plastic or cardboard.

11. Packaging unit according to one of the preceding claims, further comprising a further substrate (1') which is inserted into the second tray (4').

12. A packaging stack comprising a plurality of packaging units according to one of the preceding claims stacked on top of each other.

13. Packaging stack according to the preceding claim, further comprising a stabilizing element, which forms the closure of the packaging stack.

14. A method for packaging a substrate (1), comprising the following steps:
- providing a first tray (4),
- inserting a substrate (1) into the first tray (4), and
- placing a second tray (4') onto the first tray (4),
so that a first side of the substrate (1) is surrounded by the first tray (4), and an opposite, second side of the substrate (1) is covered by the second tray (4'),
wherein a metal deposit (2) is applied to the second side of the substrate (1), and an adhesive point (3) is arranged on the metal deposit (2), and
wherein the second tray (4') is supported on the first tray (4) in such a way that the second tray (4') touches the substrate (1) only outside the adhesive point (3),
wherein the first tray (4) comprises a bottom (7) and a circumferential wall (6), and
wherein the circumferential wall (6) extends from the bottom (7) to a wall height which lies between the height of the substrate (1) and twice the height of the substrate (1).

## Revendications

1. Unité d'emballage (10) pour un substrat (1), comprenant :
- une première barquette (4),
- un substrat (1) et
- une seconde barquette (4'),
le substrat (1) étant déposé dans la première barquette (4) et la seconde barquette (4') étant posée sur la première barquette (4), de telle sorte qu'un premier côté du substrat (1) soit entouré par la première barquette (4) et un deuxième côté opposé du substrat (1) soit recouvert par la seconde barquette (4'),
un dépôt métallique (2) étant appliqué sur le deuxième côté du substrat (1) et un point adhésif (3) étant disposé sur le dépôt métallique (2) et
la seconde barquette (4') s'appuyant sur la première barquette (4) de telle sorte que la seconde barquette (4') ne touche le substrat (1) qu'en dehors du point adhésif (3),
la première barquette (4) comprenant un fond (7) et une paroi périphérique (6) et
la paroi périphérique (6) s'étendant à partir du fond (7) jusqu'à une hauteur de paroi comprise entre la hauteur du substrat (1) et le double de la hauteur du substrat (1).

2. Unité d'emballage selon la revendication 1, dans laquelle le substrat (1) est un substrat céramo-métallique.

3. Unité d'emballage selon la revendication précédente, dans laquelle le substrat céramo-métallique (1) comprend une couche céramique (11) et au moins une couche de métallisation (12) et le dépôt métallique (2) est appliqué sur la couche de métallisation (12).

4. Unité d'emballage selon l'une quelconque des revendications précédentes, dans laquelle le dépôt métallique (2) comprend un métal pouvant être soudé ou fritté ou un alliage pouvant être soudé ou fritté.

5. Unité d'emballage selon l'une quelconque des revendications précédentes, dans laquelle la première barquette (4) et/ou la seconde barquette (4') présentent au moins un élément d'espacement (5) pour appuyer respectivement sur l'autre barquette et/ou sur le substrat (1).

6. Unité d'emballage selon la revendication précédente, dans laquelle la paroi périphérique (6) présente dans la direction du fond (7) une dimension extérieure inférieure à celle à son extrémité libre.

7. Unité d'emballage selon l'une quelconque des revendications précédentes, dans laquelle la première barquette (4) et la seconde barquette (4') sont de construction identique.

8. Unité d'emballage selon l'une quelconque des revendications précédentes, dans laquelle le point adhésif (3) est conçu pour fixer un composant électronique sur le substrat (1).

9. Unité d'emballage selon l'une quelconque des revendications précédentes, dans laquelle le substrat (1) comprend une pluralité de substrats individuels disposés les uns à côté des autres.

10. Unité d'emballage selon l'une quelconque des revendications précédentes, dans laquelle la première barquette (4) et la seconde barquette (4') sont en plastique ou en carton.

11. Unité d'emballage selon l'une quelconque des revendications précédentes, comprenant en outre un autre substrat (1'), lequel est déposé dans la seconde barquette (4').

12. Pile d'emballage comprenant une pluralité d'unités d'emballage selon l'une quelconque des revendications précédentes empilées les unes sur les autres.

13. Pile d'emballage selon la revendication précédente, comprenant en outre un élément de stabilisation, lequel forme la fin de la pile d'emballage.

14. Procédé pour l'emballage d'un substrat (1), comprenant les étapes suivantes :
- fourniture d'une première barquette (4),
- dépose d'un substrat (1) dans la première barquette (4) et
- pose d'une seconde barquette (4') sur la première barquette (4),
de telle sorte qu'un premier côté du substrat (1) soit entouré par la première barquette (4) et un deuxième côté opposé du substrat (1) soit recouvert par la seconde barquette (4'),
un dépôt métallique (2) étant appliqué sur le deuxième côté du substrat (1) et un point adhésif (3) étant disposé sur le dépôt métallique (2) et
la seconde barquette (4') s'appuyant sur la première barquette (4) de telle sorte que la seconde barquette (4') ne touche le substrat (1) qu'en dehors du point adhésif (3),
la première barquette (4) comprenant un fond (7) et une paroi périphérique (6) et
la paroi périphérique (6) s'étendant à partir du fond (7) jusqu'à une hauteur de paroi comprise entre la hauteur du substrat (1) et le double de la hauteur du substrat (1).
